# EUROPÄISCHE PATENTANMELDUNG

(11) **EP 2 442 361 A2**
(43) Veröffentlichungstag der Anmeldung: **18.04.2012**
(21) Anmeldenummer: 11185291.9
(22) Anmeldetag: 14.10.2011
(51) Int. Cl.: H01L 27/142, H01L 31/0392, H01L 31/075

(54) **Verfahren zur Herstellung von Verbindungen in einem Dünnschichtfotovoltaikmodul und Dünnschichtfotovoltaikmodul**

(30) Priorität: 15.10.2010 DE 102010048618
(71) Anmelder: Stein, Wilhelm, 01324 Dresden (DE)
(72) Erfinder: Stein, Wilhelm, 01324 Dresden (DE)
(74) Vertreter: Epping - Hermann - Fischer

(57) **Zusammenfassung**

Verfahren zur Herstellung eines Dünnschichtfotovoltaikmoduls und Dünnschichtfotovoltaikmodul

Ein Verfahren zur Herstellung eines Dünnschichtfotovoltaikmoduls, umfasst:
- Bereitstellen eines Schichtstapels mit:
- einem Substrat (1),
- einer darauf angeordneten Frontelektrode (2),
- einem darauf angeordneten Absorber (3),
- einer darauf angeordneten Rückelektrode (4),

- Ausbilden einer elektrischen Isolierung (30) in einem Bereich (10) der Rückelektrode,
- Ausbilden einer Ausnehmung in einem weiteren Bereich (20) durch die Rückelektrode (4), den Absorber (3) und die Frontelektrode (2),
- Einbringen von elektrisch isolierendem Material (31) in die Ausnehmung,
- Aufbringen von elektrisch leitfähigem Material (32) zumindest in dem weiteren Bereich (10) und teilweise in dem Bereich (10) der Rückelektrode, so dass die Rückelektrode (4) mittels des elektrisch leitfähigen Materials (32) mit der Frontelektrode (2) elektrisch gekoppelt wird.

## Beschreibung

Verfahren zur Herstellung eines Dünnschichtfotovoltaikmoduls und Dünnschichtfotovoltaikmodul

Die Erfindung betrifft ein Verfahren zur Herstellung eines Dünnschichtfotovoltaikmoduls sowie ein Dünnschichtfotovoltaikmodul.

Dünnschichtsolarzellen-Module, auch Dünnschichtfotovoltaikmodule genannt, weisen photoaktive Schichten mit Schichtdicken in der Größenordnung von Mikrometern auf. Das in der oder den photoaktiven Schichten eingesetzte Halbleitermaterial kann dabei amorph oder mikrokristallin sein. Auch eine Kombination von Schichten aus amorphen und Schichten aus mikrokristallinem Halbleitermaterial innerhalb einer Zelle ist möglich, zum Beispiel bei den so genannten Tandemzellen und den so genannten Tripelzellen. Als Halbleitermaterialien kommen Si, Ge und Verbindungshalbleiter wie CdTe oder Cu(In, Ga)Se2 (kurz CIS oder CIGS genannt) sowie Verbindungshalbleiter auf III-V-Basis (GaAs) und organische Stoffe zum Einsatz.

Um wirtschaftliche Module mit möglichst großer Fläche einsetzen zu können, ohne dass der in den Elektroden der Solarzellen lateral abgeführte Strom so groß wird, dass hohe ohmsche Verluste auftreten, werden Dünnschichtfotovoltaikmodule üblicherweise in eine Vielzahl von Segmenten unterteilt. Die streifenförmigen und in der Regel einige Millimeter bis Zentimeter breiten Segmente verlaufen dabei meist parallel zu einer Kante des Moduls. Die Segmente werden gebildet, indem bei durchgehendem Substrat einzelne Schichten des Schichtaufbaus der Solarzelle durch dünne Trennlinien unterbrochen werden. Die Trennlinien führen zum einen dazu, dass gleiche Schichten benachbarter Segmente gegeneinander elektrisch isoliert sind und zum anderen dazu, dass nachfolgend aufgebrachte Schichten entlang einer Kontaktierung mit darunter liegenden Schichten elektrisch verbunden werden können. Bei geeigneter Anordnung der Trennlinien lässt sich auf diese Weise eine Reihenschaltung der einzelnen Segmente erreichen. In dem Bereich der Trennlinien wird kein elektrischer Strom erzeugt.

Es ist wünschenswert, ein Fotovoltaikmodul anzugeben, das effizient ist. Es ist weiterhin wünschenswert, ein Verfahren zur Herstellung eines effizienten Fotovoltaikmoduls anzugeben, das eine kostengünstige Herstellung ermöglicht.

In einer Ausführungsform umfasst ein Verfahren zur Herstellung eines Dünnschichtfotovoltaikmoduls ein Bereitstellen eines Schichtstapels mit einem Substrat, einer darauf angeordneten Frontelektrode, einem darauf angeordneten Absorber und einer darauf angeordneten Rückelektrode. Eine elektrische Isolierung wird in einem Bereich zumindest der Rückelektrode ausgebildet. In die Rückelektrode, den Absorber und die Frontelektrode wird eine Ausnehmung in einem weiteren Bereich eingebracht. Die Ausnehmung wird mit einem elektrisch isolierenden Material aufgefüllt. Ein elektrisch leitfähiges Material wird auf die Rückseite des Schichtstapels zumindest in dem weiteren Bereich und teilweise dem Bereich aufgebracht, sodass die Rückelektrode mittels des elektrisch leitfähigen Materials mit der Frontelektrode elektrisch gekoppelt ist.

In einer Ausführungsform umfasst ein Dünnschichtfotovoltaikmodul ein Substrat, eine darauf angeordneten Frontelektrode, einen darauf angeordneten Absorber und eine darauf angeordneten Rückelektrode. Das Dünnschichtfotovoltaikmodul umfasst eine elektrische Isolierung in einem Bereich der Rückelektrode und eine weitere elektrische Isolierung in einem weiteren Bereich durch die Rückelektrode, den Absorber und die Frontelektrode. Das Dünnschichtfotovoltaikmodul umfasst ein elektrisch leitfähiges Material zumindest in dem weiteren Bereich und teilweise in dem Bereich der Rückelektrode, so dass die Rückelektrode mittels des elektrisch leitfähigen Materials mit der Frontelektrode elektrisch gekoppelt ist.

Der Bereich und der weitere Bereich grenzen gemäß Ausführungsformen unmittelbar aneinander an. Der Bereich und der weitere Bereich sind gemäß Ausführungsformen beabstandet zueinander angeordnet.

Das leitfähige Material wird so aufgebracht, dass es in den Bereich hineinragt, in dem die Rückelektrode entfernt wurde. Das elektrisch leitfähige Material wird so aufgebracht, dass es in diesem Bereich lediglich teilweise hineinragt und diesen nicht vollständig auffüllt. Damit ist die Rückelektrode in dem Bereich elektrisch isoliert. Das elektrisch leitfähige Material wird so aufgebracht, dass die Rückelektrode in dem Bereich elektrisch isoliert bleibt.

Das elektrisch leitfähige Material wird so aufgebracht, dass es den mit dem elektrisch isolierenden Material aufgefüllten weiteren Bereich in Schichtrichtung elektrisch überbrückt, sodass eine elektrische Verbindung zwischen der Frontelektrode auf der einen Seite des elektrisch isolierenden Materials und der Rückelektrode auf der anderen Seite des elektrisch isolierenden Materials in Schichtrichtung vorhanden ist.

Dadurch, dass die elektrische Kontaktierung zwischen der Rückelektrode und der Frontelektrode sowie die elektrische Isolierung der Rückelektrode in dem gemeinsamen Bereich, insbesondere einer gemeinsamen Ausnehmung der Rückelektrode, angeordnet werden, ist der Kontaktierungsbereich, der nicht zur Umwandlung von Strahlungsenergie in elektrische Energie beiträgt, zwischen einem ersten und einem zweiten Segment des Fotovoltaikmoduls möglichst schmal ausgebildet. Damit wird bezogen auf das Fotovoltaikmodul möglichst wenig Fläche für die Kontaktierung benötigt und entsprechend steht mehr Fläche zur Verfügung, die zur Umwandlung von Strahlungsenergie in elektrische Energie beiträgt. Bei gleichbleibender Modulgröße wird somit die Effizienz des Fotovoltaikmoduls gesteigert.

Dadurch, dass die gesamte Strukturierung gemäß Ausführungsformen in genau zwei Strukturierungsschritten durchgeführt wird und diese nicht zwischen dem Aufbringen der einzelnen Schichten des Schichtstapels, sondern nachdem alle Schichten des Schichtstapels aufgebracht wurden, durchgeführt werden, ist das Herstellungsverfahren kostengünstig.

Gemäß Ausführungsformen weist die Ausnehmung in dem Bereich, in dem die Rückelektrode entfernt ist, eine Breite in Schichtrichtung von 100 μm oder weniger auf. Insbesondere weist der Bereich eine Breite von etwa 50 μm auf. Damit sind kleine Kontaktierungsbereiche mit sehr geringen Dead Zones realisierbar.

Das elektrisch leitfähige Material wird beispielsweise mit einem Tintenstrahldruck aufgebracht. Gemäß weiteren Ausführungsformen wird das elektrisch leitfähige Material mit Maskentechnologien oder mit Siebdruckverfahren aufgebracht.

Das elektrisch leitfähige Material umfasst beispielsweise Silber. Das elektrisch leitfähige Material umfasst insbesondere eine Silber-Tinte.

### Kurze Beschreibung der Zeichnungen

Weitere Vorteile, Merkmale und Weiterbildungen ergeben sich aus den nachfolgenden in Verbindung mit den Figuren erläuterten Beispielen. Gleiche, gleichartige und gleich wirkende Elemente können in den Figuren mit den gleichen Bezugszeichen versehen sein. Die dargestellten Elemente und deren Größenverhältnisse zueinander sind grundsätzlich nicht als maßstabsgerecht anzusehen, vielmehr können einzelne Elemente, wie beispielsweise Bereiche oder Schichten zum besseren Verständnis übertrieben groß oder dick dimensioniert dargestellt sein.

Es zeigen:
- Figur 1: eine schematische Darstellung eines Fotovoltaikmoduls gemäß einer Ausführungsform,
- Figuren 2A bis 2E: schematische Darstellungen eines Schichtaufbaus eines Dünnschichtfotovoltaikmoduls, jeweils zu verschiedenen Verfahrensstadien während der Herstellungen gemäß einer Ausführungsform.

### Detaillierte Beschreibung von Ausführungsformen

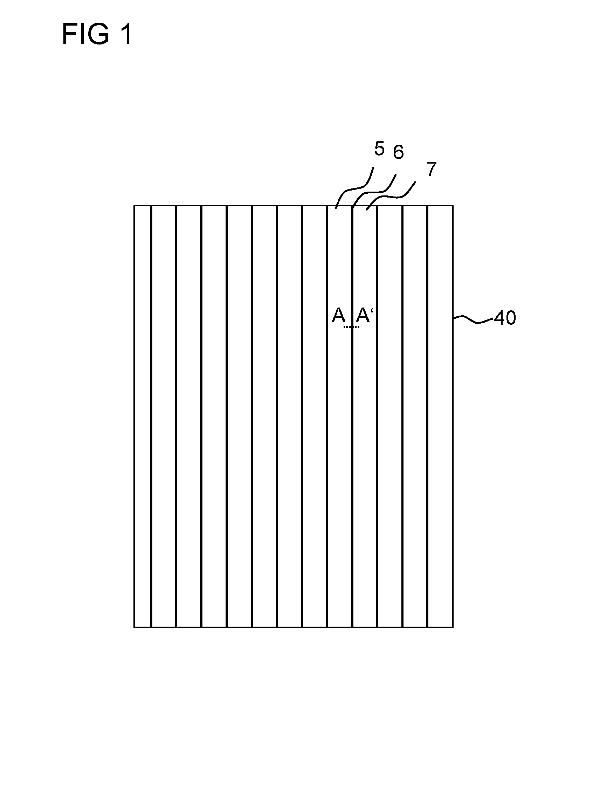

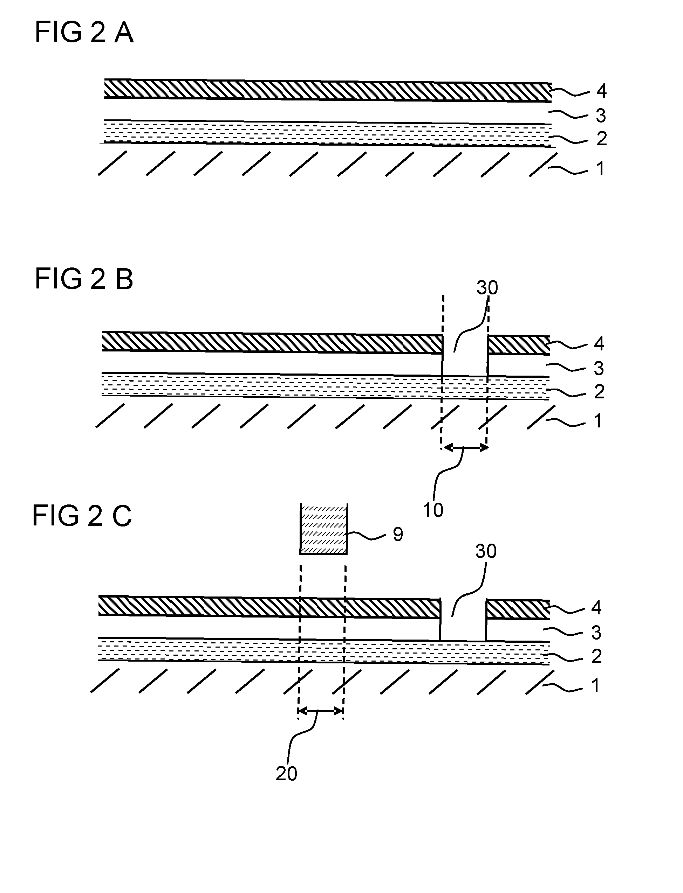

Figur 1 zeigt schematisch ein Ausführungsbeispiel eines Fotovoltaikmoduls 40, das eingerichtet ist, im betriebsfertigen Zustand Strahlungsenergie in elektrische Energie umzuwandeln. Das Fotovoltaikmodul 40 ist vom Typ eines Dünnschichtfotovoltaikmoduls, auch Dünnfilmfotovoltaikmodul genannt. Das Fotovoltaikmodul 40 weist eine Mehrzahl von Segmenten 5, 7 auf, die auf einem gemeinsamen Substrat 1 (Figur 2A) angeordnet sind. Jeweils zwei unmittelbar nebeneinander angeordnete Segmente, beispielsweise die Segmente 5 und 7, sind durch eine Trennlinie beziehungsweise durch einen Kontaktierungsbereich getrennt, beispielsweise ist zwischen den Segmenten 5 und 7 ein Kontaktierungsbereich 6 angeordnet. Das Fotovoltaikmodul 40 ist beispielsweise ein Siliziumdünnschichtfotovoltaikmodul, ein CIS-Dünnschichtfotovoltaikmodul, ein CdTe-Dünnschichtfotovoltaikmodul oder ein III-V-Dünnschichtfotovoltaikmodul. Das Fotovoltaikmodul 40 ist gemäß weiteren Ausführungsformen ein Fotovoltaikmodul, das organische Materialien umfasst.

Figur 2A zeigt eine schematische Darstellung durch einen Schichtstapel eines Dünnschichtfotovoltaikmoduls zu einem Verfahrenszeitpunkt der Herstellung des Dünnschichtfotovoltaikmoduls. Auf dem flächig ausgedehnten Substrat 1 ist quer zur Hauptausbreitungsrichtung des Substrats 1 eine elektrisch leitfähige Schicht 2 angeordnet. Die elektrisch leitfähige Schicht 2 dient in betriebsfertigem Zustand als Frontelektrode des Fotovoltaikmoduls. Auf einer dem Substrat 1 abgewandten Oberfläche der Frontelektrode 2 ist ein Absorber 3 angeordnet. Auf der dem Substrat 1 abgewandten Oberfläche des Absorbers 3 ist eine weitere elektrisch leitfähige Schicht 4 angeordnet. Die weitere elektrisch leitfähige Schicht 4 dient in betriebsfertigem Zustand als Rückelektrode.

Beispielhaft handelt es sich bei dem Substrat 1 um Flachglas, bei der ersten elektrisch leitfähigen Schicht 2 um eine Frontseitenelektrode aus TCO (TCO = Transparent Conductive Oxide Layers; transparente leitfähige Oxidschicht) und bei dem Absorber 3 um eine photoaktive Schichtfolge mit einer Abfolge von p-dotiertem, im Wesentlichen intrinsischem und n-dotiertem amorphen oder mikrokristallinem Silizium. Die erste elektrisch leitfähige Schicht 2 und die photoaktive Schichtfolge 3 können in aufeinanderfolgenden Vakuumbeschichtungsprozessen aufgebracht sein, ohne dass das Substrat 1 dazu aus dem Vakuum geschleust werden muss. Ebenso ist es möglich, mit einem Substrat 1 zu starten, das bereits mit einer TCO-Schicht als erste elektrisch leitfähige Schicht 2 versehen ist. In diesem Fall ist nur die photoaktive Schichtfolge 3 aufzubringen. Gemäß weiteren Ausführungsformen werden die erste elektrisch leitfähige Schicht 2, der Absorber 3 und die weitere elektrisch leitfähige Schicht 4 in aufeinanderfolgenden Vakuumbeschichtungsprozessen aufgebracht, ohne dass das Substrat 1 dazu aus dem Vakuum geschleust werden muss.

Die im Betrieb der Sonne zugewandte erste elektrisch leitfähige Schicht 2, die die Frontelektrode ausbildet, umfasst beispielsweise SnO2, ZnO oder ITO. Die im Betrieb der Sonne abgewandte zweite elektrisch leitfähige Schicht, die die Rückelektrode ausbildet, kann ebenfalls eine TCO-Schicht aufweisen oder auch durch Metalle wie Ag, Al, Mo oder aus Kombinationen von TCO und einer Metallschicht ausgebildet sein.

Der Absorber 3 umfasst typischerweise zumindest eine p- und eine n-dotierte Halbleiterschicht. Im Falle von Dünnschichtfotovoltaikzellen auf der Basis von Silizium werden die p- und die n-dotierten Schichten üblicherweise noch durch eine ausgedehnte im Wesentlichen intrinsische (also undotierte) Schicht (i-Schicht) getrennt. Zur besseren Ausnutzung des Wellenlängenspektrums können mehrere pin-Schichtenfolgen mit unterschiedlichen Absorberspektren übereinander in dem Absorber 3 vorgesehen sein. Eine solche Siliziumtandemzelle weist beispielsweise eine pin-Schichtfolge aus amorphem Silizium und eine pin-Schichtfolge aus mikrokristallinem Silizium auf. Es kann auch eine weitere pin-Schichtenfolge aus amorphem Siliziumgermanium vorgesehen sein. In diesem Fall spricht man von Triplezellen.

Typischerweise ist die p-dotierte Schicht im Betrieb des Fotovoltaikmoduls der Sonne zugewandt. Es ist auch möglich, dass die n-dotierte Schicht der Sonne zugewandt ist. Als Aufwachssubstrat wird Glas oder auch eine (Metall-)Folie eingesetzt. Das Trägersubstrat, durch das im Betrieb das Sonnenlicht einfällt, wird bei Verwendung einer (Metall-) Folie erst am Ende des Herstellungsprozesses auf das Modul auflaminiert. Der Schichtstapel bleibt dabei mit dem Aufwachssubstrat verbunden.

Als aktives Halbleitermaterial für den Absorber 3 können amorphe oder mikrokristalline Halbleiter der Gruppe 4, zum Beispiel a-Si, a-SiGe, µC-Si, oder Verbindungshalbleiter wie zum Beispiel CdTe oder Cu(In, Ga)Se2 (kurz CIS oder CIGS genannt) eingesetzt werden. Weiterhin kann der Absorber organisches Material umfassen, das eingerichtet ist, Strahlungsenergie in elektrische Energie umzuwandeln. Dabei können in dem Absorber 3 auch Schichten verschiedener der genannten Materialien kombiniert werden. Weiterhin können in dem Absorber 3 teilweise spiegelnde Schichten (intermediate reflectors) aus einem leitfähigen Oxid und/oder einer leitfähigen Halbleiterschicht vorgesehen sein.

Figur 2B zeigt einen weiteren Verfahrensschritt. Eine elektrische Isolierung 30 ist in einem Bereich 10 in die Rückelektrode 4 und den Absorber 3 eingebracht worden. Gemäß weiteren Aspekten ist die Isolierung 30 nur in die Rückelektrode 4 eingebracht. Die elektrische Isolierung 30 trennt die Rückelektrode 4 so, dass die zwei angrenzenden Bereiche der Rückelektrode 4 beidseitig der elektrischen Isolierung 30 elektrisch voneinander getrennt sind. Die elektrische Isolierung 30 ist im gezeigten Ausführungsbeispiel eine Ausnehmung in der Rückelektrode 4 und dem Absorber 3.

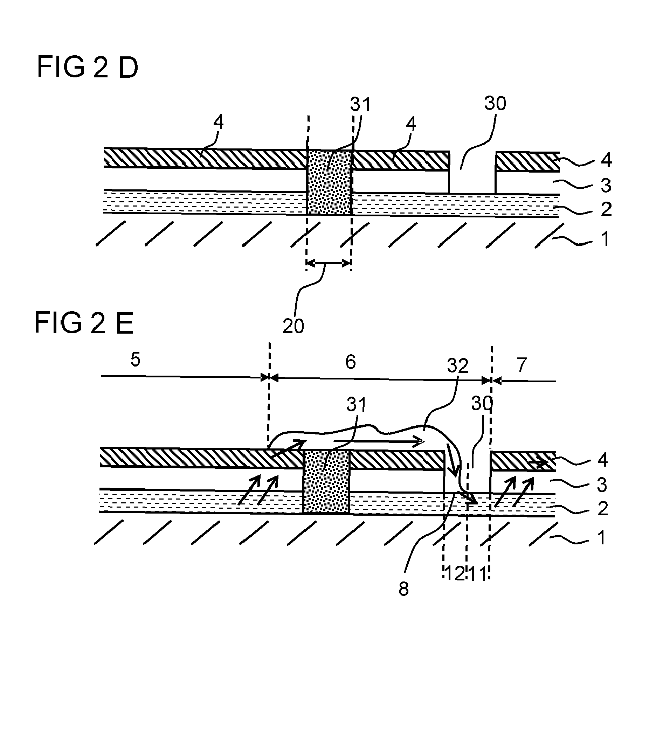

Die Ausnehmung weist gemäß Ausführungsformen eine Breite von bis zu 100 µm in Schichtrichtung auf, beispielsweise eine Breite von bis zu 80 µm. Insbesondere weist die Ausnehmung in Schichtrichtung eine Breite von 50 µm auf. Die Ausnehmung weist eine Breite auf, sodass in den nachfolgenden Verfahrensschritten (vergleiche Figur 2E) elektrische leitfähiges Material 32 so aufgebracht werden kann, dass diese einen Teil 12 der Ausnehmung auffüllt und ein anderer Teil 11, der in Schichtrichtung neben dem ersten Teil 12 angeordnet ist, frei von dem elektrisch leitfähigen Material bleibt.

Die Frontelektrode 4 wird durch das Einbringen der Ausnehmung im Bereich 10 nicht oder nur unwesentlich beschädigt. Die Frontelektrode 4 ist in dem Bereich 10 elektrisch leitfähig.

Die Ausnehmung wird insbesondere durch ein Einstrahlen eines Laserstrahls in den Schichtstapel eingebracht.

In dem in Figur 2C schematisch dargestellten Verfahrensschritt wird in einem weiteren Bereich 20 die Rückelektrode 4, der Absorber 3 und die Frontelektrode 2 quer zur Schichtrichtung durchtrennt. Dadurch wird eine weitere Ausnehmung in den Schichtstapel eingebracht. Die weitere Ausnehmung reicht durch die Rückelektrode 4, den Absorber 3 und insbesondere durch die Frontelektrode 2, sodass die Frontelektrode 2 durchtrennt ist. Die Ausnehmung trennt die Frontelektrode 2 so, dass die zwei angrenzenden Bereiche der Rückelektrode 2 beidseitig der Ausnehmung elektrisch voneinander getrennt sind.

Die Ausnehmung wird insbesondere durch ein Einstrahlen eines Laserstrahls 9 in den Schichtstapel eingebracht.

Die Ausnehmung wird mit einem elektrisch isolierenden Material 31 aufgefüllt, wie in Figur 2D schematisch dargestellt. Das elektrisch isolierende Material 31 wird so in die Ausnehmung eingebracht, dass es von der Frontelektrode bis zu der der Frontelektrode abgewandten Oberfläche der Rückelektrode 4 reicht. Das elektrisch isolierende Material 31 wird gemäß weiteren Ausführungsformen so in die Ausnehmung eingebracht, dass es von der Frontelektrode bis zu dem Absorber 3 reicht. Durch das elektrisch isolierende Material 31 wird eine elektrische Isolierung in dem weiteren Bereich 20 ausgebildet.

Das elektrisch isolierende Material 31 umfasst beispielsweise ein Heisswachs, wie es zum Maskieren von Zellen in der kristallinen Silizium-Fotovoltaik verwendet wird, inbesondere für Ätzmasken. Das elektrisch isolierende Material 31 umfasst beispielsweise einen elektrisch isolierenden Kunststoff, insbesondere auf Basis von Silicone, Epoxy und/oder Acryl.

Das elektrisch leitfähige Material 32 umfasst beispielsweise eine elektrisch leitfähige Tinte mit Silber-Partikeln und/oder Kupfer-, Nickel-, Aluminium-Partikeln und/oder anderen leitfähigen Materialien.

Figur 2E zeigt schematisch den Querschnitt durch das Dünnschichtfotovoltaikmodul, nachdem es vollständig strukturiert wurde. Zur elektrischen Kopplung zwischen der Rückelektrode 4 und der Frontelektrode 3 wird das leitfähiges Material 32 so zumindest in den Bereichen 10 und 20 der beiden Ausnehmungen aufgebracht, dass die Rückelektrode 4 beidseitig des isolierenden Materials auf der dem Substrat abgewandten Oberfläche bedeckt ist und das elektrisch leitfähige Material 32 in die Ausnehmung der Rückelektrode 4 hineinreicht. Das elektrisch leitfähige Material 32 überbrückt die elektrische Isolierung 31 der Rückelektrode 4 elektrisch, so dass ein Stromfluss in Schichtrichtung über den Bereich 20 hinweg möglich ist. Das elektrisch leitfähige Material 32 ist elektrisch mit der Rückelektrode 4 gekoppelt. Das elektrisch leitfähige Material 32 ist elektrisch mit der Frontelektrode 2 gekoppelt.

Das elektrische leitfähige Material 32 ist so aufgebracht, dass das elektrisch leitfähige Material 32 den Teil 12 der Ausnehmung auffüllt und den anderen Teil 11, der in Schichtrichtung neben dem ersten Teil 12 angeordnet ist, frei von dem elektrisch leitfähigen Material bleibt. In dem Teil 12 weist das elektrische leitfähige Material 32 eine gemeinsame Kontaktfläche 8 mit einer dem Substrat abgewandten Oberfläche der Frontelektrode 2 auf. Zwischen dem elektrisch leitfähigen Material 32 und der Frontelektrode 2 besteht ein ohmscher Kontakt. Die dem Substrat abgewandten Oberfläche der Frontelektrode 2 ist in dem Bereich 10 in dem Verfahrensschritt zur Figur 2B freigelegt worden.

Das elektrisch leitfähige Material 32 ist gemäß Ausführungsformen eine viskose Masse, beispielsweise eine Paste. Das elektrisch leitfähige Material 32 ist geeignet, durch ein Druckverfahren aufgebracht zu werden. Das elektrisch leitfähige Material 32 wird beispielsweise mit einem Tintenstrahldruck aufgebracht. Gemäß weiteren Ausführungsformen wird das elektrisch leitfähige Material 32 mit Maskentechnologien oder mit Siebdruckverfahren aufgebracht.

Das elektrisch leitfähige Material 32 ist gemäß Ausführungsformen von dem Material der Rückelektrode 4 verschieden.

Das erste Segment 5 und das zweite Segment 7 sind über das elektrisch leitfähige Material 32 im Kontaktierungsbereich 6 elektrisch in Reihe gekoppelt. Zur elektrischen Unterbrechung der Frontelektrode 2 zwischen dem Segment 5 und dem Segment 7 ist die elektrische Isolierung 31 in den Schichtstapel eingebracht, die die Frontelektrode 2 links von der Isolierung von der Frontelektrode 2 rechts von der Isolierung elektrisch isoliert. Die elektrische Isolierung 30 isoliert die photoaktive Schichtfolge und die zweite elektrisch leitfähige Schicht 4 links von der elektrischen Isolierung 30 elektrisch von der photoaktiven Schichtfolge 3 und der Rückelektrode 4 rechts von der elektrischen Isolierung.

Durch das elektrisch leitfähige Material 32 besteht ein ohmscher Kontakt zwischen der Rückelektrode 4 und der Frontelektrode 2. Das elektrisch leitfähige Material 32 reicht von der dem Substrat abgewandten Oberfläche der Rückelektrode 4 bis zu der Frontelektrode 2.

Die Schritte zur Strukturierung der Schichten 2, 3 und 4 in dem Kontaktierungsbereich 6 führen zu einer Serienverschaltung der beiden Segmente 5 und 7, wie durch die den Stromverlauf symbolisierenden Pfeile in der Figur 2E ersichtlich.

Gemäß weiteren Ausführungsformen werden die beiden Ausnehmungen so in die Rückelektrode 4 beziehungsweise den gesamten Schichtstapel eingebracht, dass sie direkt aneinander angrenzen. Auf den Teil des Absorbers 3 und der Rückelektrode 4, der beispielsweise im Ausführungsbeispiel der Figur 2E zwischen dem elektrisch isolierenden Material und der Ausnehmung der Rückelektrode 4 angeordnet ist, kann verzichtet werden. Beispielsweise wird das elektrisch isolierende Material lediglich so eingebracht, dass es die Ausnehmung der Frontelektrode 2 auffüllt.

Die Reihenfolge der Strukturierungsschritte, insbesondere die Reihenfolge der Einbringung der beiden Ausnehmungen, kann beliebig vertauscht werden. Das leitfähige Material 32 wird aufgebracht, nachdem beide Ausnehmungen eingebracht wurden und die Ausnehmung in dem weiteren Bereich 20 zumindest teilweise mit dem isolierenden Material 31 aufgefüllt wurde. Die Strukturierungsmaßnahmen zum Einbringen der Ausnehmungen werden gemäß Ausführungsformen von einem einzigen Prozesskopf ausgeführt. So kommt es zwischen der elektrischen Isolierung 30 und der elektrischen Isolierung 31 bei der Herstellung zu keinen Toleranzschwankungen, die berücksichtigt werden müssen. Gemäß weiteren Ausführungsformen werden die Strukturierungsmaßnahmen zur Ausbildung der elektrischen Isolierung 30, zur Ausbildung der Kontaktierung 31 und zur Ausbildung der Trennlinie 32 gemäß Figur 2B von mehreren Prozessköpfen ausgeführt, die an einer gemeinsamen Strukturierungsanlage angeordnet sind.

Bei dem Fotovoltaikmodul wie im Zusammenhang mit den Figuren 1 und 2 erläutert sowie dem Verfahren zur Herstellung von Fotovoltaikmodulen werden die Schichten 2, 3 und 4 derart strukturiert, dass die Reihenverschaltung ausgeführt wird, nachdem bereits alle Schichten der Schichten 2, 3 und 4 auf das Substrat aufgebracht wurden. Die Zusammenfassung der Prozessschritte zum Aufbringen der Schichten resultiert insbesondere bei Dünnschichtfotovoltaikmodulen in geringeren Verunreinigungen, zum Beispiel durch häufiges Ein- und Ausschleusen in und aus Vakuumkammern, und somit in einer besseren Schichtqualität, aus der sich eine höhere Effizienz der Zelle ergibt.

Darüber hinaus können bei den vorgestellten Fotovoltaikmodulen die Prozessschritte zum Strukturieren von Schichten zusammengefasst werden, was eine bessere Positionierung der Strukturierungsmaßnahme in den verschiedenen Schichten zueinander führt. Dadurch ergibt sich ein in Hauptausbreitungsrichtung der Schichten kleinerer Kontaktbereich 6 für die Reihenverschaltung und folglich ein höherer Flächenertrag des Fotovoltaikmoduls. Dadurch, dass auf den herkömmlichen Pattern 2, bei dem Rückelektrode durch eine separate Ausnehmung des Absorbers geführt wird, um die Reihenschalung zu ermöglichen, verzichtet wird, ergibt sich ein in Hauptausbreitungsrichtung der Schichten kleinerer Kontaktbereich 6 für die Reihenverschaltung und folglich ein höherer Flächenertrag des Fotovoltaikmoduls. Zudem ist der Herstellungsprozess zeitlich effektiver, wenn weniger Einund Ausschleuseprozesse durchgeführt werden müssen und Strukturierungsmaßnahmen in einem gemeinsamen Prozesskopf zusammengeführt werden. Dies führt auch zu einer Kosteneinsparung, sowohl bei den Herstellungsanlagen, als auch während der Produktion. Auch wird für die Herstellungsanlagen weniger Fläche benötigt. Auf zusätzliche Reinigungsschritte zwischen den einzelnen Beschichtungsprozessen kann verzichtet werden. Damit kann auch dann auf die dafür notwendigen Produktionsanlagen verzichtet werden.

### Bezugszeichen

- 1: Substrat
- 2: Frontelektrode
- 3: Absorber
- 4: Rückelektrode
- 5, 7: Segment
- 6: Kontaktierungsbereich
- 8: Kontaktfläche
- 9: Laserstrahl
- 10: Bereich
- 11: Teil
- 12: Teil
- 20: Bereich
- 30: elektrische Isolierung
- 31: elektrische Isolierung
- 32: elektrisch leitfähiges Material
- 40: Fotovoltaikmodul

## Patentansprüche

1. Verfahren zur Herstellung eines Dünnschichtfotovoltaikmoduls, umfassend:
- Bereitstellen eines Schichtstapels mit:
- einem Substrat (1),
- einer darauf angeordneten Frontelektrode (2),
- einem darauf angeordneten Absorber (3),
- einer darauf angeordneten Rückelektrode (4),
- Ausbilden einer elektrischen Isolierung (30) in einem Bereich (10) der Rückelektrode,
- Ausbilden einer Ausnehmung in einem weiteren Bereich (20) durch die Rückelektrode (4), den Absorber (3) und die Frontelektrode (2),
- Einbringen von elektrisch isolierendem Material (31) in die Ausnehmung,
- Aufbringen von elektrisch leitfähigem Material (32) zumindest in dem weiteren Bereich (10) und teilweise in dem Bereich (10) der Rückelektrode, so dass die Rückelektrode (4) mittels des elektrisch leitfähigen Materials (32) mit der Frontelektrode (2) elektrisch gekoppelt wird.

2. Verfahren nach Anspruch 1, bei dem das elektrisch leitfähige Material (32) durch ein Druckverfahren aufgebracht wird.

3. Verfahren nach Anspruch 1 oder 2, bei dem das elektrisch leitfähige Material (32) so aufgebracht wird, dass es in dem Bereich (10) eine gemeinsame Kontaktfläche mit der Frontelektrode (8) aufweist.

4. Verfahren nach einem der Ansprüche 1 bis 3, bei dem das elektrisch leitfähige Material (32) so aufgebracht wird, dass ein Teil (11) der Frontelektrode (2) in dem Bereich (10) frei von dem elektrisch leitfähigen Material (32) bleibt.

5. Dünnschichtfotovoltaikmodul, umfassend:
- ein Substrat (1),
- eine darauf angeordneten Frontelektrode (2),
- einen darauf angeordneten Absorber (3),
- eine darauf angeordneten Rückelektrode (4),
- eine elektrische Isolierung (30) in einem Bereich (10) der Rückelektrode,
- eine weitere elektrische Isolierung (31) in einem weiteren Bereich (20) durch die Rückelektrode (2), den Absorber (3) und die Frontelektrode (2),
- ein elektrisch leitfähiges Material (32) zumindest in dem weiteren Bereich (10) und teilweise in dem Bereich (10) der Rückelektrode (4), so dass die Rückelektrode (4) mittels des elektrisch leitfähigen Materials (32) mit der Frontelektrode (2) elektrisch gekoppelt ist.

6. Dünnschichtfotovoltaikmodul nach Anspruch 5, bei dem das elektrisch leitfähige Material (32) in dem Bereich (10) eine gemeinsame Kontaktfläche mit der Frontelektrode (8) aufweist.

7. Dünnschichtfotovoltaikmodul nach Anspruch 5 oder 6, bei dem ein Teil (11) der Frontelektrode (2) in dem Bereich (10) frei von dem elektrisch leitfähigen Material (32) ist.

8. Dünnschichtfotovoltaikmodul nach einem der Ansprüche 5 bis 7, bei dem das elektrisch leitfähige Material (32) die Rückelektrode (4) beidseitig der weiteren elektrischen Isolierung (31) elektrisch miteinander koppelt.
